# EUROPEAN PATENT SPECIFICATION

(11) **EP 2 356 741 B1**
(45) Date of publication and mention of the grant of the patent: **04.01.2017**
(21) Application number: 09751999.5
(22) Date of filing: 10.11.2009
(51) Int. Cl.: H03F 1/30

(54) **BIASED POWER AMPLIFIER**
VORGESPANNTER LEISTUNGSVERSTÄRKER
AMPLIFICATEUR DE PUISSANCE POLARISÉ

(30) Priority: 10.11.2008 EP 08168769
(43) Date of publication of application: 17.08.2011
(73) Proprietor: Nederlandse Organisatie voor toegepast- natuurwetenschappelijk onderzoek TNO, 2595 DA 's-Gravenhage (NL)
(72) Inventor: VAN WANUM, Maurice, NL-2274 HW Den Haag (NL); DE HEK, Andries Peter, NL-3371 HX Hardinxveld Giessendam (NL); BUSKING, Erik Bert, NL-2564 TK Den Haag (NL)
(74) Representative: V.O.
(86) International application number: PCT/NL2009/050680
(87) International publication number: WO 2010/053372

(56) References cited:
- EP-A- 0 625 822
- EP-A- 1 793 491
- WO-A-02/29971
- WO-A-2006/036060
- US-A1- 2007 040 613

## Description

### Field of the invention

The invention relates to a power amplifier comprising an amplifying transistor and a bias circuit for the amplifying transistor.

### Background

WO2007064201 discloses a power amplifier with an amplifying transistor of "normally on" type and a bias circuit that supplies a bias voltage to the gate of the amplifying transistor. The source of the amplifying transistor is coupled to ground and the drain is coupled to a positive power supply via a load impedance. An RF input is coupled to the gate via a capacitor. A "normally on" transistor, also called depletion mode transistor, is a transistor that can be switched to a non-conductive state only by a control electrode voltage outside the range of voltage values between the voltages at the terminals of its main current channel. This type of amplifying circuit suffers from deviations from the nominal threshold voltage of the amplifying transistor, due to manufacturing tolerances and/or temperature fluctuations.

The bias circuit is used to vary the gate voltage of the amplifying transistor in such a way that the threshold voltage deviations are compensated. The bias circuit comprises a bias transistor of the same "normally on" type as the amplifying transistor, with a drain coupled to ground via a drain resistance. To supply the bias voltage the drain is connected to the gate of the amplifying transistor via an RF blocking element such as a choke coil. The source and gate of the bias transistor are coupled to a negative power supply via respective resistors. The drain resistance has a value selected to ensure that the bias transistor circuit provides unity gain of the difference between the bias transistor's gate-source voltage and its own threshold voltage. As a result, the amplifying transistor receives a gate voltage that varies with deviations of the threshold voltage of the bias transistor. Thus the difference between the gate-source voltage of the amplifying transistor and its threshold voltage may be kept independent of the deviations.

This circuit has been found to have the problem a bias shift may occur when a large RF signal swing is applied to the amplifying transistor, which disturbs the compensation.

US 2007/040613 shows an amplifier with an amplifier transistor that has a bias circuit with a loop of a reference transistor and a first buffer transistor.

The amplifier transistor is a "normally off'(enhancement mode) transistor, so that the circuit can operate on a single power supply. The first reference transistor is in a common source circuit configuration. The first buffer transistor in a common drain circuit with its gate coupled to the drain of the reference transistor and its souce coupled to the gate of the reference transistor. Thus, the reference transistor effectively appears as a diode connection between its source and drain.

A second buffer transistor is provided in parallel with the first buffer transistor, except that its source is coupled to the gate of the amplifier transistor. Thus a copy of the gate voltage of the reference transistor is applied to the gate of the amplifier transistor. US 2007/040613 does not discuss the gain of the transistors, but the use of a first reference transistor in a common source circuit suggest that as high a gain as possible is used, which suppresses external influences on the bias voltage and make it depend mainly on the drain resistor. There is no suggestion that a specific, low gain should be used to improve temperature compensation and in the circuit of US 2007/040613 this would make no sense.

### Summary

Among others it is an object to counteract the effects of large signal swing at the amplifying transistor without losing compensation for deviations of the threshold voltage.

A power amplifier according to claim 1 is provided, with a bias stage that is coupled to the control electrode of an amplifying transistor via a buffer circuit. The bias stage comprises a bias transistor and at least both at least the amplifying transistor and the bias transistor are of the same "normally on" type. The bias stage controls a bias voltage at the control electrode of the amplifying transistor and the buffer stage prevents that the bias stage is affected by DC current shift in the bias line resulting from the signal swing at the amplifying transistor. The bias stage compensates for deviations of the threshold voltage of both the amplifying transistor and one or more buffer transistors in the buffer stage, by providing voltage gain of substantially an integer factor from the control electrode of the bias transistor to the control electrode of the amplifying transistor.

In an embodiment exactly one buffer transistor is used, in which case said gain is two. When a larger number of buffer transistors is used the integer factor may be correspondingly higher, so that the integer factor equals one plus the number (one or higher) of buffer transistors coupled between the bias stage and the control electrode of the amplifying transistor.

In an embodiment field effect transistors may be used, the buffer transistor or buffer transistors being coupled in source follower configuration between the bias stage and the control electrode of the amplifying transistor. As used herein "source follower configuration" of a buffer transistor means that in the bias signal path from the bias stage to the amplifying transistor the control electrode (gate) of the buffer transistor is coupled towards the bias stage and the source is coupled towards the gate of the amplifying transistor.

In an embodiment the bias transistor is a field effect transistor with a source resistance and a drain resistance coupled to different power supply connections. In this embodiment the required gain may be realized through the selection of the resistance values of these resistances. Preferably, these source and drain resistances determine the entire gain, but if further transistors are used between the bias transistor and the gate of the amplifying transistor, the resistance values may compensate for gain or attenuation factors due to such transistors.

The circuit makes it possible to add various additional compensations in the bias stage without suffering from the effects of large signal swing at the amplifying transistor. For example one or more pull up resistances may be added coupled from the source of the bias transistor to the first and/or intermediate power supply connection.

### Brief description of the drawing

These and other objects and advantageous aspects will become apparent from a description of exemplary embodiments, using the following figures.
Figures 1 to 4 show amplifier circuits
Figures 1a and 3a show a Vgs-Ids characteristic of a normally on transistor

### Detailed description exemplary embodiments

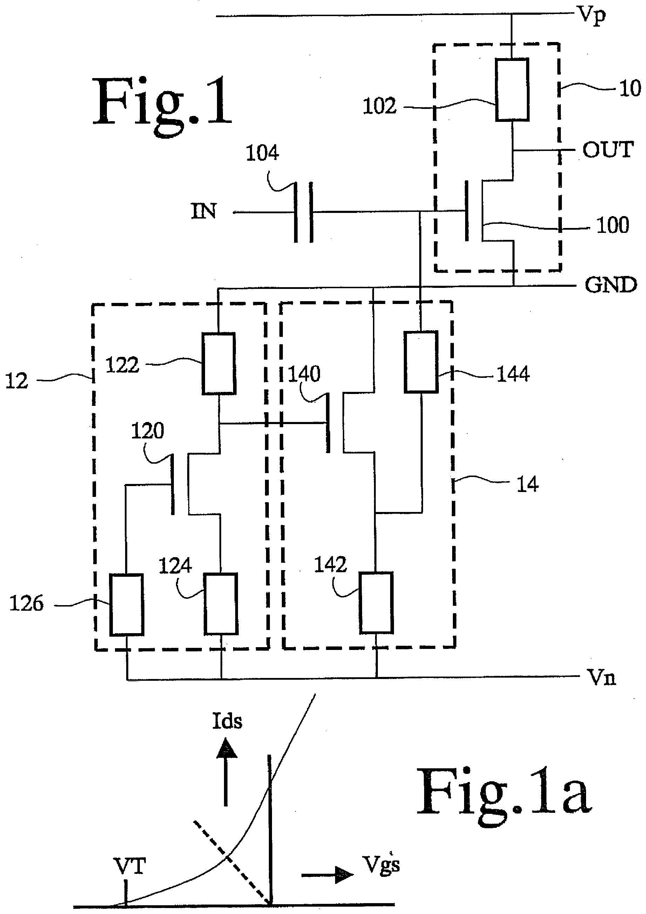

Figure 1 shows an amplifier circuit, comprising an amplifying stage 10 with an amplifying transistor 100, a bias stage 12 with a bias transistor 120 and a buffer stage 14 with a buffer transistor 140 in source follower configuration. Amplifying transistor 100, bias transistor 120 and buffer transistor 140 may be junction FETs or isolated gate FETs for example. The circuit has a positive power supply connection Vp, a negative power supply connection Vn and a ground connection GND. Amplifying transistor 100, a bias transistor 120 and buffer transistor 140 may be transistors of "normally on" type, i.e. transistors with a main current channel that conducts when a zero gate-source voltage is applied and cut off when the gate source voltage is lowered. Figure 1a shows a Vgs-Ids characteristic of a normally on transistor, which shows a function F(Vgs-Vt) that determines Ids as a function of the gate source voltage Vgs and the threshold voltage VT. A qualitative example of the shape of the characteristic is shown as an illustration of principle. The characteristic for real transistors may differ from this qualitative example. When VT shifts, the entire curve shifts. As can be seen in the normally on transistor the transistor operates above its threshold voltage when Vgs=0.

A source of amplifying transistor 100 is coupled to the ground connection. Amplifying stage 10 comprises a drain impedance 102 coupled between the positive power supply connection Vp and coupled to the drain of amplifying transistor 100, a coupling capacitor 104 coupled between an RF input 'IN' and the gate of amplifying transistor 100.

Bias stage 12 comprises a drain resistance 122 coupled between the drain of bias transistor 120 and ground, a source resistance 124 coupled between the source of bias transistor 120 and negative power supply Vn and a gate resistance 126 coupled between the gate of bias transistor 120 and negative power supply Vn. A dashed line in figure 1a illustrates the relation between the gate source voltage of bias transistor 120 and the drain-source current defined by the source resistance. A ratio of the resistance values of drain resistance 122 and source resistance 124 is selected to realize a voltage gain of substantially two from the gate of bias transistor 120 to the gate voltage of amplifying transistor 100. If the gain of buffer stage 14 may be taken to be one, the drain resistance 122 and source resistance 124 may be selected to realize a voltage gain of substantially two from the gate of bias transistor 120 to the drain voltage of bias transistor 120. Although the output of bias stage 12 is shown at a node that forms the drain of bias transistor 120, it will be appreciated that the output could be located elsewhere, for example at a node in a series arrangement of resistances between the drain and ground, or in a more complicated network of resistances. As will be appreciated, it is straightforward to set the gain to the described value in this case as well. The resistance value of gate resistance 126 is not critical, since the DC current to the gate of bias transistor is negligible.

The gate of buffer transistor 140 is coupled to the drain of bias transistor 120. The drain of buffer transistor 140 is coupled to ground. Buffer stage 14 comprises a resistance 142 coupled between the source of buffer transistor 140 to the negative power supply Vn and an RF blocker 144 coupled from the source of buffer transistor 140 to the gate of amplifying transistor 100. RF blocker 144 may be a choke coil for example, but any circuit may be used that conducts DC current and provides a high RF impedance at the gate of transistor 100. The RF impedance ensures that amplifying stage 14 operates properly and well matched, which could be as is the case in many designs a substantially inductive impedance. The RF blocker may also contain a capacitor, connected between the source of transistor 140 to GND.

In operation bias stage 12 supplies a voltage at the drain of bias transistor 120 that depends on the threshold voltage of bias transistor 120. Manufacturing tolerances and/or temperature fluctuations in the threshold voltage result in deviations of the drain voltage that are substantially twice as large. Similarly, between circuits that have the same structure, but different threshold voltages due to manufacturing spread, the drain voltages at the drains of bias transistor 120 will differ by substantially twice the difference in the threshold voltage. The factor between the deviations of the threshold voltage and the drain voltage of bias transistor may be slightly higher than two if buffer transistor 140 is dimensioned so that it produces a gain of less than one, so that the combined gain of bias stage 12 and buffer stage 14 substantially equals two.

Buffer transistor 140 operates in source follower configuration. It transmits the drain voltage of bias transistor 120 to the gate of amplifying transistor 100. Buffer transistor 140 introduces an additional dependence on temperature fluctuations and/or manufacturing spread, due to deviations in its threshold voltage. This dependence reduces the double dependence on deviations at the gate voltage of buffer transistor 140 to a single dependence at its source. In other words, the source voltage has a dependence substantially equal to the deviation of the threshold voltage. As a result the deviation dependence on the threshold voltage of amplifying transistor 100 is compensated.

In a further embodiment, further compensating resistances (not shown) may be added from the source of bias transistor 120 to ground and/or positive power supply Vp. The resistance values of the drain resistance 122 and/or the source resistance 124 may be adapted to realize the gain of two in combination with such additional resistances.

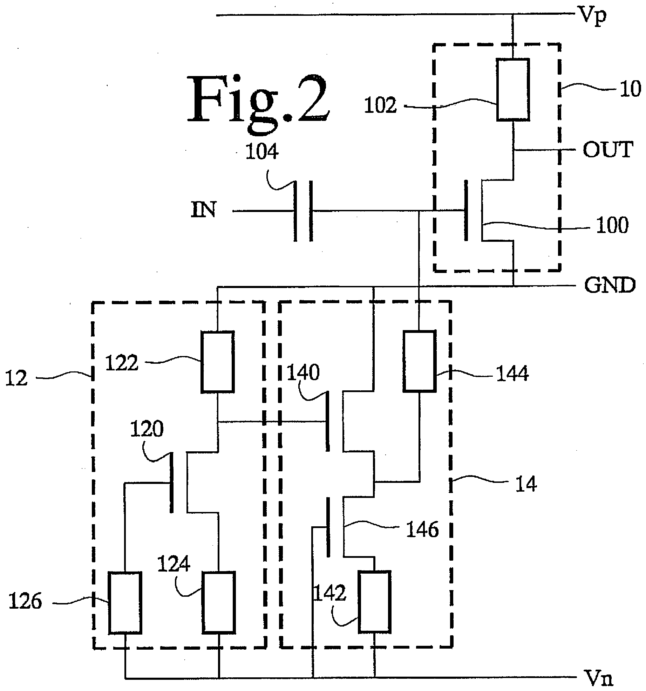

Figure 2 shows a further embodiment wherein a current source transistor 146 has been added to buffer circuit 14. The main current channel of current source transistor 146 is coupled between the source of buffer transistor 140 and the resistance 142 of buffer stage 14. Thus, resistance 142 is coupled between the source of current source transistor 146 and the negative power supply Vn. The gate of transistor 146 is connected to Vn, optionally via a resistor (not indicated in Figure 2). In operation current source transistor 146 and resistance 142 act to supply a constant current to buffer transistor 140. This keeps the gain of buffer stage 14 close to one, which makes it possible to provide for accurate compensation of the deviations without the need to know the parameters of buffer transistor 140 when the gain of bias stage 12 is set.

In another embodiment, a Darlington configuration may be used in buffer stage 14. In this embodiment the gate-source connection of one or more additional transistors may be added in series between the drain of bias transistor 120 and the gate of buffer transistor 140. In this case the additional transistors introduce additional deviation dependence, which can be compensated by using a correspondingly higher gain in bias stage 12, so that the gain from the gate of bias transistor 120 to the gate of amplifying transistor 100 substantially equals N+1, where N is the number of gate-source connections in the signal path through buffer stage 14.

Although not shown, further transistors in other configurations may be included between the drain of the bias transistor and the amplifying transistor. Preferably, the value of the gain of bias stage 12 is set to compensate for amplification or attenuation contributed by such further transistors.

Although an embodiment of a circuit with field effect transistors has been shown, it should be appreciated that a circuit with any other type of transistor, such as bipolar transistors may be used, if circuit components are added to compensate for non-zero base currents. Also, it will be appreciated that the polarity of the power supply connections may be reversed, accompanied by a reversal of the polarity type of the transistors.

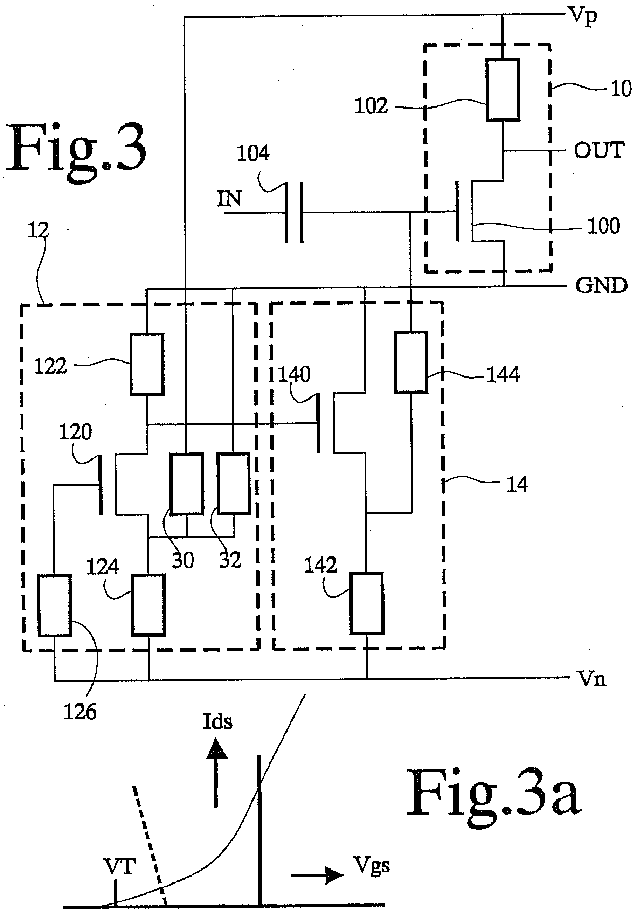

Figure 3 shows an embodiment wherein, pull-up resistors 30, 32 have been added, coupled between the source of bias transistor 120 and GND and Vp respectively. A buffer circuit 14 similar to that of figure 1 is shown, but it should appreciated that alternatively, the buffer circuit of figure 2 may be used. A ratio of the resistance values of drain resistance 122, pull-up resistor 128 and source resistance 124 is selected to realize the voltage gain of substantially two from the gate of bias transistor 120 to the gate voltage of amplifying transistor 100. In other embodiments only one of pull-up resistors 30, 32 may be used, for example only a pull-up resistor to ground, or only a pull-up resistor to the positive power supply.

Basically, as can be shown by conventional circuit analysis, pull-up resistors 30, 32 have the effect that the circuit coupled to the source of bias transistor 120 can be modelled as an effective circuit with an effective voltage source with an output voltage Vq above the level of the negative power supply Vn, in series with an effective resistance Rq that corresponds to the combination of the resistances that are coupled to the source. Figure 3a shows an example of source voltage current relation defined by Vq and Rq with a dashed line, together with a relation between gate-source voltage and source (drain) current of bias transistor 120.

In operation, the drain current satisfies Ids=F(Vgs-VT) and Vgs= -Vq-Ids*Rq, wherein the function F is characteristic of the gate source voltage channel current relation of bias transistor 120. The effective resistance Rq may be made lower than the source resistance. Thus it is easier to realize a raised gain with bias transistor 120 and the effect of transistor parameters other than threshold shift on the bias output is reduced, which results in a more complete compensation for threshold voltage variations. The raised output voltage Vq of the effective voltage source at the source of bias transistor 120 helps to reduce the overall channel current of bias transistor 120, so that a larger drain resistor can be used while maintaining a correct bias voltage for transistor 100. In the present case the selection of the combination of resistances depends on the required gain of the bias stage.

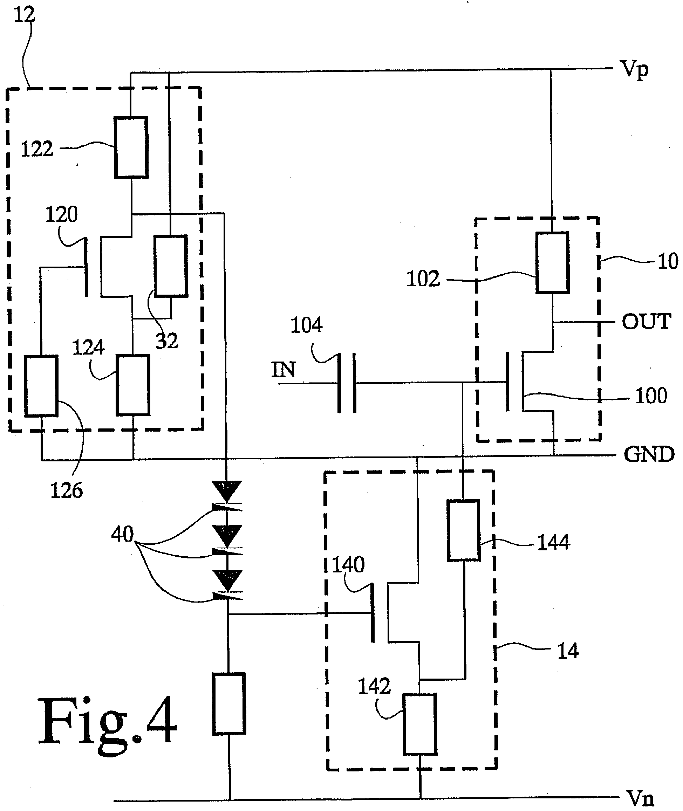

Figure 4 shows an embodiment wherein bias circuit 12 is fed from positive supply connection Vp and ground and a level shift circuit has been added between bias circuit 12 and buffer circuit 14. By way of example, an embodiment is shown wherein the level shift circuit is implemented by means of a series connection of diodes 40 coupled between the output of bias circuit 12 and the input of buffer circuit 14 and a resistance between the input of buffer circuit 14 and the negative power supply. Diodes 40 may be used to provide for additional temperature compensation. Although a pull-up resistor 32 is shown to provide for refined compensation, it should be appreciated that other embodiments this resistor may be omitted. In another embodiment resistor 142 may be replaced by a current source as formed in Fig 2 by FET 146 and resistor 142. In another embodiment with a level shift circuit, bias circuit 12 may be fed from positive supply connection Vp and the negative power supply connection, instead of ground and the negative power supply connection, as shown in figure 1 to 3.

Although an embodiment has been shown with normally on bias and amplifying transistors and a positive and negative power supply, it should be appreciated that instead normally off (enhancement mode) transistors bias and amplifying transistors coupled via a buffer could be used, in combination with a single power supply. In this case, a connection between the gate and the source of the bias transistor does not suffice to provide for a temperature compensated bias voltage.

In such a circuit a drain side gate current supply circuit, such as resistor between the gate of the bias transistor and the power supply connection of its drain must be used. In the circuit with normally on transistors no circuit from the gate of the bias transistor to the drain side power supply need be used. As a result of the drain side gate current supply circuit, the current through the bias transistor may not depend only or even primarily on the threshold voltage of the bias transistor, but also on the gate current supply circuit. As far as this produces a bias voltage with a useful temperature dependence at the drain of the bias transistor, this voltage may be coupled to the gate of the amplifying transistor via a buffer circuit. Preferably the bias transistor is configured to communicate the temperature effect to its drain with a gain that is equal to one plus the number of buffer transistors coupled between the drain of the bias transistor and the amplifying transistor in the buffer circuit.

## Claims

1. A power amplifier having first and second power supply connections (Vp, Vn) for supplying power supply voltages of mutually opposite polarity relative to an intermediate power supply connection (Gnd), the power amplifier comprising
- a normally on amplifying transistor (100) with a control electrode, and a main current channel coupled between the first power supply connection (Vp) and the intermediate power supply connection (Gnd);
- a bias stage (12) with an output coupled to the control electrode of the amplifying transistor (100), the bias stage (12) comprising a normally on bias transistor (120) in a reference configuration wherein a main current channel of the bias transistor (120) is coupled between the intermediate power supply connection (Gnd) and the second power supply connection (Vn), and wherein a current through the main current channel of the bias transistor (120) depends on a threshold voltage value of the bias transistor (120), **characterized by** a buffer circuit (14) coupled between the bias stage and the control electrode of the amplifying transistor (100), the buffer circuit (14) comprising at least one buffer transistor (140) in source follower configuration; the combination of the bias stage (12) and the buffer circuit (14) having a voltage gain of substantially an integer factor from a control electrode of the bias transistor (120) to the control electrode of the amplifying transistor (100), the integer factor being equal to one plus a count of buffer transistors (140) coupled between the bias transistor (120) and the amplifying transistor (100) in the buffer circuit (14).

2. A power amplifier according to claim 1, wherein the bias stage (12) comprises a first and second resistance (122, 124) coupled between the main current channel of the bias transistor (120) and mutually different ones of the power supply connections (Vp, Vn) respectively, the first and second resistance (122, 124) having resistance values set to realize said voltage gain.

3. A power amplifier according to claim 1 or 2, wherein the bias transistor (120), the buffer transistor (140) and the amplifier transistor (100) are field effect transistors and the count of buffer transistors (140) is a count of buffer transistors (140) connected in source follower configuration between the bias stage (12) and the amplifying transistor (100).

4. A power amplifier according to claim 3, wherein exactly one buffer transistor (140) is connected in source follower configuration between the output of the bias stage (12) and the control electrode of the amplifying transistor (100) and wherein the integer factor is two.

5. A power amplifier according to any one of the preceding claims, comprising a current source (146) coupled between the main current channel of the buffer transistor (140) and the second power supply connection (Vn).

6. A power amplifier according to claim 2, comprising a further resistance (30) coupled from the source of the bias transistor (120) to the first power supply connection (Vp).

7. A power amplifier according to claim 2 or 6, comprising a further resistance (32) coupled from the source of the bias transistor (120) to the intermediate power supply connection (GND).

8. A power amplifier according to any one of the preceding claims, wherein the main current channel of the bias transistor (120) is coupled between the second power supply connection (Vn) and the intermediate power supply connection (Gnd).

9. A power amplifier according to any one of the preceding claims, wherein the buffer circuit (14) couples the bias transistor (120) in feed forward to the control electrode of the amplifier transistor (100), without feeding back to the bias transistor (120).

10. A method of amplifying a signal using power amplifier having first and second power supply connections (Vp, Vn) for supplying power supply voltages of mutually opposite polarity relative to an intermediate power supply connection (Gnd), wherein a main current channel is coupled between the first power supply connection (Vp) and the intermediate power supply connection (Gnd); and wherein a main current channel of the bias transistor (120) is coupled between the intermediate power supply connection (Gnd) and the second power supply connection (Vn) the method comprising
- using the bias transistor to generate a bias voltage at a control electrode of an amplifying transistor, **characterized by**
- buffering an output voltage from the bias transistor with a buffer transistor;
- providing a voltage gain of substantially an integer factor from a control electrode of the bias transistor to the control electrode of the amplifying transistor, wherein the integer factor is equal to one plus a count of buffer transistors coupled between the bias stage and the amplifying transistor in the buffer circuit.

## Patentansprüche

1. Leistungsverstärker mit ersten und zweiten Stromversorgungsanschlüssen (Vp, Vn), um Stromversorgungsspannungen von zueinander entgegengesetzter Polarität in Bezug auf einen Zwischenstromversorgungsanschluss (Gnd) zu liefern, der Leistungsverstärker umfassend
- einen normalerweise eingeschalteten Verstärkungstransistor (100) mit Steuerelektrode und einen Hauptstromkanal, gekoppelt zwischen dem ersten Stromversorgungsanschluss (Vp) und dem Zwischenstromversorgungsanschluss (Gnd);
- eine Vorspannungsphase (12) mit einem Ausgang, gekoppelt an die Steuerelektrode des Verstärkungstransistors (100), die Vorspannungsphase (12) umfassend einen normalerweise eingeschalteten Vorspannungstransistor (120) in einer Referenzkonfiguration, wobei ein Hauptstromkanal des Vorspannungstransistors (120) zwischen dem Zwischenstromversorgungsanschluss (Gnd) und dem zweiten Stromversorgungsanschluss (Vn) gekoppelt ist und wobei ein Strom durch den Hauptstromkanal des Vorspannungstransistors (120) von einem Schwellenspannungswert des Vorspannungstransistors (120) abhängt, **gekennzeichnet durch** einen Pufferkreis (14), gekoppelt zwischen der Vorspannungsphase und der Steuerelektrode des Verstärkungstransistors (100), der Pufferkreis (14) umfassend mindestens einen Puffertransistor (140) in Sourcefolgerkonfiguration; wobei die Kombination der Vorspannungsphase (12) und des Pufferkreises (14) eine Spannungsverstärkung von im Wesentlichen einem Ganzzahlfaktor von einer Steuerelektrode des Vorspannungstransistors (120) zu der Steuerelektrode des Verstärkungstransistors (100) aufweist, welcher Ganzzahlfaktor gleich eins plus einer Anzahl von Puffertransistoren (140), gekoppelt zwischen dem Vorspannungstransistor (120) und dem Verstärkungstransistor (100) in dem Pufferkreis (14) ist.

2. Leistungsverstärker nach Anspruch 1, wobei die Vorspannungsphase (12) einen ersten und zweiten Widerstand (122, 124), gekoppelt zwischen dem Hauptstromkanal des Vorspannungstransistors (120) bzw. voneinander verschiedenen der Stromversorgungsanschlüsse (Vp, Vn) umfasst, wobei der erste und zweite Widerstand (122, 124) Widerstandswerte aufweisen, die eingestellt sind, um die Spannungsverstärkung zu erzielen.

3. Leistungsverstärker nach Anspruch 1 oder 2, wobei der Vorspannungstransistor (120), der Puffertransistor (140) und der Verstärkungstransistor (100) Feldeffekttransistoren sind und die Anzahl von Puffertransistoren (140) eine Anzahl von Puffertransistoren (140), angeschlossen in Sourcefolgerkonfiguration zwischen der Vorspannungsphase (12) und dem Verstärkungstransistor (100), ist.

4. Leistungsverstärker nach Anspruch 3, wobei genau ein Puffertransistor (140) in Sourcefolgerkonfiguration zwischen dem Ausgang der Vorspannungsphase (12) und der Steuerelektrode des Verstärkungstransistors (100) angeschlossen ist und wobei der Ganzzahlfaktor zwei ist.

5. Leistungsverstärker nach einem der vorhergehenden Ansprüche, umfassend eine Stromquelle (146), gekoppelt zwischen dem Hauptstromkanal des Puffertransistors (140) und dem zweiten Stromversorgungsanschluss (Vn).

6. Leistungsverstärker nach Anspruch 2, umfassend einen weiteren Widerstand (30), gekoppelt von der Quelle des Vorspannungstransistors (120) zu dem ersten Stromversorgungsanschluss (Vp).

7. Leistungsverstärker nach Anspruch 2 oder 6, umfassend einen weiteren Widerstand (32), gekoppelt von der Quelle des Vorspannungstransistors (120) zu dem Zwischenstromversorgungsanschluss (GND).

8. Leistungsverstärker nach einem der vorhergehenden Ansprüche, wobei der Hauptstromkanal des Vorspannungstransistors (120) zwischen dem zweiten Stromversorgungsanschluss (Vn) und dem Zwischenstromversorgungsanschluss (Gnd) gekoppelt ist.

9. Leistungsverstärker nach einem der vorhergehenden Ansprüche, wobei der Pufferkreis (14) den Vorspannungstransistor (120) in Vorwärtskopplung an die Steuerelektrode des Verstärkungstransistors (100) koppelt, ohne Rückkopplung zu dem Vorspannungstransistor (120).

10. Verfahren zur Verstärkung eines Signals unter Verwendung eines Leistungsverstärkers mit ersten und zweiten Stromversorgungsanschlüssen (Vp, Vn), um Stromversorgungsspannungen von zueinander entgegengesetzter Polarität in Bezug auf einen Zwischenstromversorgungsanschluss (Gnd) zu liefern, wobei ein Hauptstromkanal zwischen dem ersten Stromversorgungsanschluss (Vp) und dem Zwischenstromversorgungsanschluss (Gnd) gekoppelt ist und wobei ein Hauptstromkanal des Vorspannungstransistors (120) zwischen dem Zwischenstromversorgungsanschluss (Gnd) und dem zweiten Stromversorgungsanschluss (Vn) gekoppelt ist, das Verfahren umfassend
- die Verwendung des Vorspannungstransistors zum Erzeugen einer Vorspannung an einer Steuerelektrode eines Verstärkungstransistors, **gekennzeichnet durch**
- Puffern einer Ausgangsspannung von dem Vorspannungstransistor mit einem Puffertransistor;
- Bereitstellen einer Spannungsverstärkung von im Wesentlichen einem Ganzzahlfaktor von einer Steuerelektrode des Vorspannungstransistors zu der Steuerelektrode des Verstärkungstransistors, wobei der Ganzzahlfaktor gleich eins plus einer Anzahl von Puffertransistoren, gekoppelt zwischen der Vorspannungsphase und dem Verstärkungstransistor in dem Pufferkreis, ist.

## Revendications

1. Amplificateur de puissance ayant des première et seconde connexions d'alimentation de puissance (Vp,Vn) pour alimenter des tensions d'alimentation de puissance de polarités mutuellement opposées par rapport à une connexion d'alimentation de puissance intermédiaire (Gnd), l'amplificateur de puissance comprenant :
- un transistor d'amplification normalement actif (100) ayant une électrode de commande, et un canal de courant principal relié entre la première connexion d'alimentation de puissance (Vp) et la connexion d'alimentation de puissance intermédiaire (Gnd) ;
- un étage de polarisation (12) ayant une sortie reliée à l'électrode de commande du transistor d'amplification (100), l'étage de polarisation (12) comprenant un transistor de polarisation normalement actif (120) dans une configuration de référence dans laquelle un canal de courant principal du transistor de polarisation (120) est relié entre la connexion d'alimentation de puissance intermédiaire (Gnd) et la seconde connexion d'alimentation de puissance (Vn), et dans lequel un courant à travers le canal de courant principal du transistor de polarisation (120) dépend d'une valeur de tension de seuil du transistor de polarisation (120), **caractérisé par** un circuit tampon (14) relié entre l'étage de polarisation et l'électrode de commande du transistor d'amplification (100), le circuit tampon (14) comprenant au moins un transistor tampon (140) dans une configuration suiveuse de source ; la combinaison de l'étage de polarisation (12) et du circuit tampon (14) ayant un gain de tension d'un facteur sensiblement entier depuis une électrode de commande du transistor de polarisation (120) vers l'électrode de commande du transistor d'amplification (100), le facteur entier étant égal à 1 plus un nombre de transistors tampons (140) reliés entre le transistor de polarisation (120) et le transistor d'amplification (100) dans le circuit tampon (14).

2. Amplificateur de puissance selon la revendication 1, dans lequel l'étage de polarisation (12) comprend une première et une seconde résistances (122, 124) reliées entre le canal de courant principal du transistor de polarisation (120) et mutuellement différentes des connexions d'alimentation de puissance (Vp, Vn) respectivement, les première et seconde résistances (122, 124) ayant des valeurs de résistance fixées pour réaliser le gain de tension.

3. Amplificateur de puissance selon la revendication 1 ou 2, dans lequel le transistor de polarisation (120), le transistor tampon (140) et le transistor d'amplification (100) sont des transistors à effet de champ et le nombre de transistors tampons (140) est le nombre de transistors tampons (140) reliés dans une configuration suiveuse de source entre l'étage de polarisation (12) et le transistor d'amplification (100).

4. Amplificateur de puissance selon la revendication 3, dans lequel exactement un transistor tampon (140) est relié dans une configuration suiveuse de source entre la sortie de l'étage de polarisation (12) et l'électrode de commande du transistor d'amplification (100) et dans lequel le facteur entier est de deux.

5. Amplificateur de puissance selon l'une quelconque des revendications précédentes, comprenant une source de courant (146) reliée entre le canal de courant principal du transistor tampon (140) et la seconde connexion d'alimentation de puissance (Vn).

6. Amplificateur de puissance selon la revendication 2, comprenant une résistance supplémentaire (30) reliée depuis la source du transistor de polarisation (120) à la première connexion d'alimentation de puissance (Vp).

7. Amplificateur de puissance selon les revendications 2 ou 6, comprenant une résistance supplémentaire (32) reliée depuis la source du transistor de polarisation (120) à la connexion d'alimentation de puissance intermédiaire (GND).

8. Amplificateur de puissance selon l'une quelconque des revendications précédentes, dans lequel le canal de courant principal du transistor de polarisation (120) est relié entre la seconde connexion d'alimentation de puissance (Vn) et la connexion d'alimentation de puissance intermédiaire (Gnd).

9. Amplificateur de puissance selon l'une quelconque des revendications précédentes, dans lequel le circuit tampon (14) relie le transistor de polarisation (120) alimentant vers l'avant à l'électrode de commande du transistor d'amplification (100), sans alimentation en retour vers le transistor de polarisation (120).

10. Méthode d'amplification d'un signal en utilisant un amplificateur de puissance ayant des première et seconde connexions d'alimentation de puissance (Vp, Vn) pour alimenter des tensions d'alimentation de puissance de polarités mutuellement opposées par rapport à une connexion d'alimentation de puissance intermédiaire (Gnd), dans lequel un canal de courant principal est relié entre la première connexion d'alimentation de puissance (Vp) et la connexion d'alimentation de puissance intermédiaire (Gnd) ; et dans lequel un canal de courant principal du transistor de polarisation (120) est relié entre la connexion d'alimentation de puissance intermédiaire (Gnd) et la seconde connexion d'alimentation de puissance (Vn), la méthode consistant à :
- utiliser le transistor de polarisation pour produire une tension de polarisation au niveau d'une électrode de commande du transistor d'amplification, **caractérisé par**
- tamponner une tension de sortie provenant du transistor de polarisation à l'aide d'un transistor tampon,
- fournir un gain de tension sensiblement d'un facteur entier depuis une électrode de commande du transistor de polarisation jusqu'à l'électrode de commande du transistor d'amplification, dans laquelle le facteur entier est égal à un plus un nombre de transistors tampons reliés entre l'étage de polarisation et le transistor d'amplification dans le circuit tampon.
